## Europäisches Patentamt

## European Patent Office

## Office européen des brevets

(19)

(11) Veröffentlichungsnummer: **0 353 762**
**A2**

(12)

# EUROPÄISCHE PATENTANMELDUNG

(21) Anmeldenummer: **89114393.5**

(22) Anmeldetag: **03.08.89**

(51) Int. Cl.⁴: **H05K 7/14 , H01R 31/06**

(30) Priorität: **03.08.88 DE 3826433**

(43) Veröffentlichungstag der Anmeldung:
**07.02.90 Patentblatt 90/06**

(84) Benannte Vertragsstaaten:
**AT BE CH DE ES FR GB GR IT LI LU NL SE**

(71) Anmelder: **WALDNER electronics GmbH & Co.**
**Hermann-Hummel-Strasse 4**
**D-8032 Gräfelfing(DE)**

(72) Erfinder: **Peröbner, Helmut**
**Hermann-Hummel-Strasse 4**
**D-8032 Gräfelfing(DE)**

(74) Vertreter: **WILHELMS, KILIAN & PARTNER**
**Patentanwälte**
**Eduard-Schmid-Strasse 2**
**D-8000 München 90(DE)**

(54) **Adaptervorrichtung.**

(57) Adaptervorrichtung zum Verbinden der Anschlüsse eines auf einem Träger angeordneten Gerätes mit einer fest montierten Anschlußplatte. Ein
Halteelement (2) ist am Träger angebracht und eine
Adapterplatte (3), die auf der der Anschlußplatte
zugewandten Seite des Halteelementes (2) vorgesehen ist, ist in einer Ebene parallel zu ihrer Plattenoberfläche bewegbar am Halteelement (2) gehalten.
In der Adapterplatte (3) ist eine Anschlußleiste mit
durchgehenden Anschlüssen auf beiden Seiten der
Adapterplatte (3) aufgenommen, wobei die Anschlüsse auf einer Seite der Adapterplatte (3) durch das
Halteelement (2) zugänglich sind und auf der dem
Halteelement (2) gegenüberliegenden Seite der
Adapterplatte (3) Paßeinrichtungen (6) zum Einpassen der Anschlußplatte (5) vorgesehen sind.

Fig. 3

## Adaptervorrichtung

Die Erfindung betrifft eine Adaptervorrichtung zum Verbinden der Anschlüsse eines auf einem Träger angeordneten Gerätes mit einer fest montierten Anschlußplatte.

Eine derartige Adaptervorrichtung eignet sich insbesondere zum Verbinden der Anschlüsse eines elektrischen Gerätes auf einem Geräteschlittent, der in ein Leitungskanalbord eingesetzt werden kann, mit der im Leitungskanalbord angeordneten Anschluß- oder Steckerplatte. Eine derartige Anordnung ist aus der DE-OS 37 39 815 bekannt.

Es sind weiterhin Steckerverbindungen bekannt, die aus zwei Bauteilen bestehen, die jeweils mit ineinandersteckbaren Steckerleisten versehen sind, wobei in dem einen Bauteil kegelförmige Löcher vorgesehen sind, in die jeweils ein Gegenkonus paßt, der am anderen Bauteil ausgebildet ist.

Wenn eine derartige Steckerverbindung dann benutzt wird, wenn der eine Steckerteil fest montiert ist und der andere Steckerteil an einem Träger angebracht ist, auf dem sich das anzuschließende Gerät befindet, so kann es vorkommen, daß aufgrund von Fertigungstoleranzen des Trägersystems bezüglich des fest montierten Steckerteils ein genaues und vollständiges Ineinanderpassen der beiden Steckerteile und dementsprechend ein genaues und vollständiges Ineinandergreifen der jeweiligen Steckerleisten nicht mehr möglich ist.

Derartige Abweichungen können aufgrund von Fertigungstoleranzen oder aufgrund der Tatsache auftreten, daß sich das Trägersystem beispielsweise das eingangs genannte Leitungskanalbord während längerer Benutzungsdauer durch die Belastung verzieht.

Die der Erfindung zugrundeliegende Aufgabe besteht daher darin, eine Adaptervorrichtung der eingangs genannten Art zu schaffen, die Abweichungen von der normalen relativen Lage zwischen dem Träger, auf dem das anzuschließende Gerät angeordnet ist, und der fest montierten Anschlußplatte ausgleichen kann.

Diese Aufgabe wird gemäß der Erfindung durch die Ausbildung gelöst, die im Kennzeichen des Patentanspruchs 1 angegeben ist.

Die erfindungsgemäße Adaptervorrichtung ist so ausgebildet, daß die Adapterplatte sozusagen schwimmend oder schwebend an dem Halteelement angeordnet ist, das am Träger für das anzuschließende Gerät angebracht ist. Wenn somit der Träger mit dem daran angebrachten Halteelement und der daran schwimmend gehaltenen Adapterplatte über die daran vorgesehene Paßeinrichtung mit der Anschlußplatte zusammengepaßt wird, ist beim Zusammenpassen eine Bewegung der Adapterplatte in einer Ebene parallel zu ihrer Plattenoberfläche, d.h. in einer Ebene senkrecht zur Einpaßrichtung möglich. Wenn somit das Halteelement mit der daran angebrachten Adapterplatte in die festangeordnete Anschlußplatte eingepaßt wird, dann kann die Adapterplatte aufgrund der Paßführung der Anschlußplatte so relativ zum Halteelement verschoben werden, daß die in beiden Bauteilen vorgesehenen Anschlußleisten vollständig und genau ineinander gepaßt werden können.

Auf diese Weise ist eine individuelle Anpassung eines Trägers mit einem darauf angeordneten Gerät an verschiedene Arbeitsplätzen, beispielsweise eines Leitungskanalbordes möglich, obwohl an den verschiedenen Arbeitsplätzen Unterschiede in der relativen Lage zwischen den Führungen für den Träger des Gerätes und der fest montierten Anschlußplatte auftreten können.

Besonders bevorzugte Ausbildungen und Weiterbildungen der erfindungsgemäßen Adaptervorrichtung sind Gegenstand der Patentansprüche 2 bis 6.

Im folgenden wird anhand der zugehörigen Zeichnung ein besonders bevorzugtes Ausführungsbeispiel der erfindungsgemäßen Vorrichtung näher beschrieben. Es zeigen

Fig. 1 und 2 eine Vorderansicht bzw. eine Seitenansicht einer Abdeckhaube mit dem Ausführungsbeispiel der erfindungsgemäßen Adaptervorrichtung,

Fig. 3 eine Querschnittsansicht durch das Ausführungsbeispiel der erfindungsgemäßen Adaptervorrichtung,

Fig. 4 eine Rückansicht auf das Ausführungsbeispiel der erfindungsgemäßen Adaptervorrichtung,

Fig. 5 eine Querschnittsansicht der Paßeinrichtung zwischen der Adapterplatte und der Anschlußplatte und

Fig. 6 eine Querschnittsansicht der Halterung zwischen der Adapterplatte und dem Halteelement.

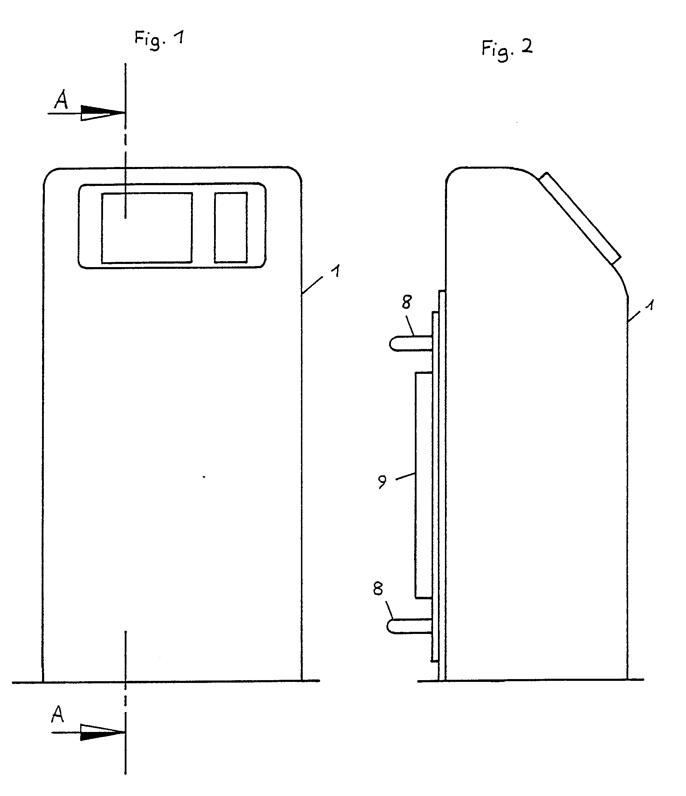

Wie es in den Fig. 1 und 2 der Zeichnung dargestellt ist, kann die Adaptervorrichtung von einer Abdeckhaube 1 umschlossen sein, in der Ausnehmungen oder Aussparungen vorgesehen sind, durch die die Anschlußkabel des anzuschließenden Gerätes hindurchführen.

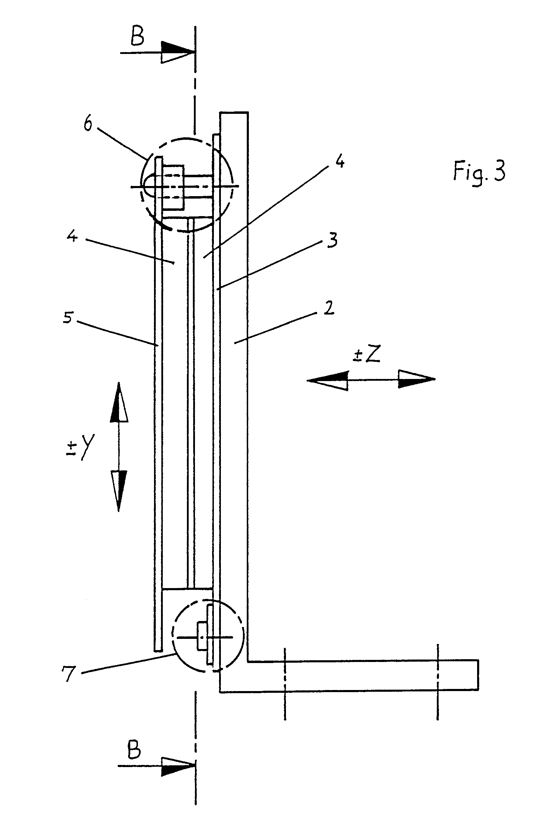

Das im einzelnen in Fig. 3 dargestellte Ausführungsbeispiel der erfindungsgemäßen Adaptervorrichtung umfaßt ein Halteelement 2, das beispielsweise in Form eines Winkelelementes ausgebildet ist und mit einem Winkelschenkel fest an einem nichtdargestellten Träger angebracht ist, auf dem das anzuschließende Gerät, beispielsweise ein elektrisches Gerät, angeordnet ist oder die Rückwand eines anzuschließenden Gerätes bildet. Das Halteelement 2 weist eine Ausnehmung auf, durch die hindurch die Anschlüsse, beispielsweise die Steckerstifte einer Steckerleiste, zugänglich sind, die in einer Adapterplatte 3 so angeordnet ist, daß ihre Anschlüsse durch die Adapterplatte 3 von einer Seite zur anderen verlaufen.

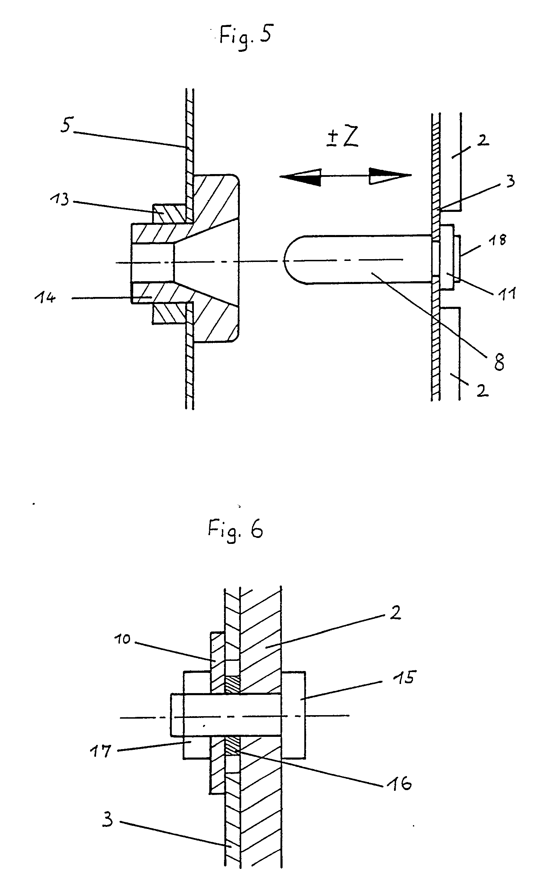

Das Halteelement 2 ist weiterhin mit zwei durchgehenden Bohrungen versehen, die insbesondere an diametral gegenüberliegenden Ecken des Haltelementes 2 ausgebildet sind. In diesen Bohrungen sind Stifte mit Muttern 11, oder Bolzen 18, aufgenommen, die an der dem Halteelement 2 zugewandten Seite der Adapterplatte 3 vorstehen. Der Außendurchmesser dieser Bolzen 18 oder Muttern 11 ist kleiner als der Innendurchmesser der durchgehenden Bohrungen im Halteelement 2 (siehe Fig. 5).

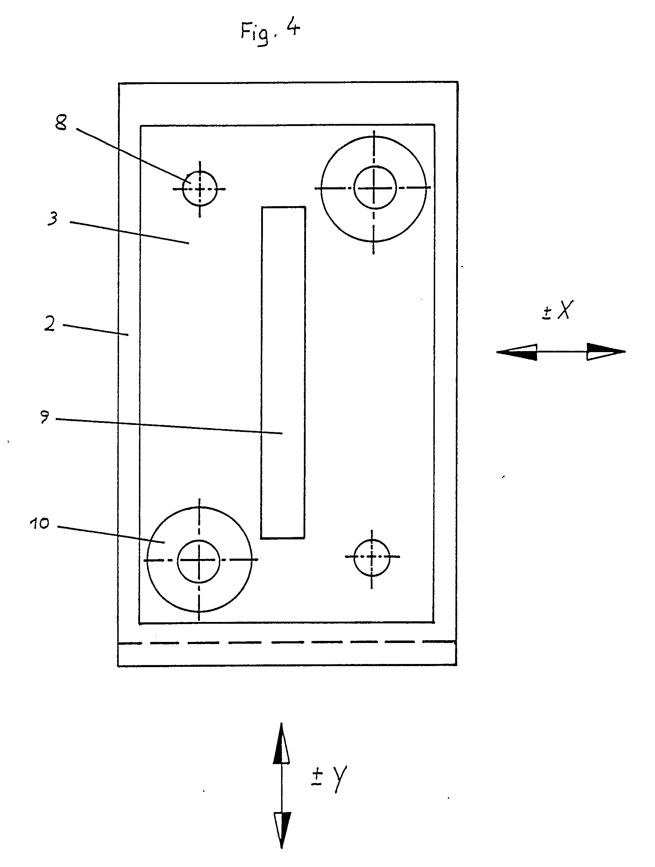

Die Adapterplatte 3 ist am Halteelement·2 über eine Halteeinrichtung 7 (Fig. 2) mit zwei weiteren Stiften, insbesondere Bolzen 15 angebracht, wie es in Fig. 6 dargestellt ist. Die Bolzen 15 führen durch das Halteelement 2 in durchgehende Bohrungen in der Adapterplatte 3, die vorzugsweise an diametral gegenüberliegenden Ecken der Adapterplatte 3 ausgebildet sind. Auf den Bolzen 15 sitzt jeweils eine Distanzhülse 16, die eine Stärke hat, die etwas größer als die Stärke der Adapterplatte 3 ist, so daß dann, wenn die Bolzen 15 über eine Mutter 17 und eine Abdeckscheibe 10 mit einem Außendurchmesser, der größer als der Innendurchmesser der Bohrungen in der Adapterplatte 3 ist, gesichert ist, d.h. die Mutter 17 angezogen ist, ein ausreichendes Spiel zwischen der Adapterplatte 3 und dem Halteelement 2 bleibt, so daß beide Elemente gegeneinander in einer Ebene parallel zu ihren Oberflächen, d.h. in X- und Y-Richtung in Fig. 3 und 4 bewegbar sind. Wenn die Steckerhälfte der Steckerleiste 9 in der Adapterplatte 3, die durch eine Ausnehmung im Halteelement 2 zugänglich ist, durch diese Ausnehmung im Halteelement 2 vorsteht, so ist die Ausnehmung in X- und Y-Richtung gleichfalls so bemessen, daß die genannte Relativbewegung zwischen dem Halteelement 2 und der Adapterplatte 3 möglich ist. Diese Relativbewegung wird somit durch eine Art schwimmende Lagerung dieser beiden Bauteile 2 und 3 über die jeweils in den Bauteilen vorgesehenen durchgehenden Bohrungen, die Ausnehmung im Halteelement 2 sowie die Stifte oder Bolzen in den durchgehenden Bohrungen gewährleistet, deren Durchmesser kleiner als der Innendurchmesser der Bohrungen ist.

An der dem Halteelement 2 abgewandten Seite der Adapterplatte 3, an der sich die Muttern 17 zum Sichern der Bolzen 15 des Halteelements 2 befinden, sind gleichfalls vorzugsweise an diametral gegenüberliegenden Ecken zwei Paßstifte 8 vorgesehen, die über eine Mutter 11 an der Adapterplatte 3 befestigt sind, wie es in Fig. 5 dargestellt ist. Diese Paßstifte 8 bilden einen Teil einer Zentriereinrichtung 6 in Fig. 3, die dazu dient, die Adapterplatte 3 mit einer fest montierten Anschluß- oder Steckerplatte paßgenau zusammenzuführen. Dazu können in der fest montierten Steckerplatte 5 konische Zentrierhülsen 14 vorgesehen sein, die über eine Mutter 13 an der Steckerplatte 5 befestigt sind.

Wenn beispielsweise ein elektrisches Gerät, das auf dem Träger angeordnet ist, an dem das Halteelement 2 befestigt ist, mit der fest montierten Steckerplatte 5 verbunden werden soll, dann werden zunächst die Anschlüsse des elektrischen Gerätes mit der durch das Halteelement 2 zugänglichen Hälfte der Steckerleiste 9 in der Adapterplatte 3 verbunden. Anschließend wird das aus dem Träger mit dem darauf angeordneten elektrischen Gerät dem daran angebrachten Halteelement 2 sowie der daran schwimmend gelagerten Adapterplatte 3 bestehende Bauelement in Richtung auf die fest montierte Steckerplatte 5 bewegt. Dabei treten die Paßstifte 8, die an der Adapterplatte 3 angebracht sind, in die Zentrierhülsen 14 der Steckerplatte 5 ein. Durch eine insbesondere halbkugelförmige Ausbildung des vorderen Endes der Paßstifte 8 kann dafür gesorgt werden, daß die Paßstifte 8 paßgenau in die Zentrierhülsen 14 eingepaßt wird. Positionsabweichungen in X-oder Y-Richtung können dabei dadurch ausgeglichen werden, daß die Adapterplatte 3 aufgrund ihrer schwimmenden Lagerung in diesen Richtungen bewegt wird, so daß ein genaues Zusammenpassen der Adapterplatte 3 mit der Steckerplatte 5 gewährleistet ist. Dabei werden auch die Steckerhälfte der Steckerleiste 9 in der Adapterplatte 3 und die gegenüberliegende Steckerhälfte 4 der Steckerplatte 5 miteinander in Eingriff gebracht, so daß die elektrische Verbindung zwischen dem elektrischen Gerät und dem Stecker in der fest montierten Steckerplatte 5 hergestellt ist.

Aus dem obigen ist ersichtlich, daß aufgrund der schwimmenden oder schwebenden Halterung der Adapterplatte 3 an dem fest an Träger angebrachten Halteelement 2 Positionsungenauigkeiten und Positionsabweichungen zwischen der Anordnung des Trägers und der fest montierten Steckerplatte 5 ausgeglichen werden können, so daß beispielsweise bei der Anordnung des Trägers an einem mehrere Arbeitsplätze aufweisenden Leitungskanalbord, an dem in regelmäßigen Abständen derartige fest montierte Steckerplatten 5 vorgesehen sind, das Bauteil aus Träger mit Halteelement 2 und Adapterplatte 3 sowie im auf dem Träger angeordneten Gerät wahlweise an verschieden Arbeitsplätzen angeordnet und durch Zusammenpassen der Adapterplatte 3 mit der an dem jeweiligen Arbeitsplatz fest montierten Steckerplatte 5 angeschlossen werden kann, selbst wenn Paßungenauigkeiten oder Abweichungen der relativen Anordnung zwischen den zusammenzufügenden Bauteilen in X- und Y-Richtung auftreten.

## Ansprüche

1. Adaptervorrichtung zum Verbinden der Anschlüsse eines auf einem Träger angeordneten Gerätes mit einer fest montierten Anschlußplatte, **gekennzeichnet** durch ein Halteelement (2), das am Träger angebracht ist, und eine Adapterplatte (3), die auf der der Anschlußplatte zugewandten Seite des Halteelementes (2) in einer Ebene parallel zu ihrer Plattenoberfläche bewegbar gehalten ist und in der eine Anschlußleiste mit durchgehenden Anschlüssen auf beiden Seiten der Adapterplatte (3) aufgenommen ist, die von der der Adapterplatte (3) abgewandten Seite des Halteelementes (2) zugänglich sind, wobei auf der dem Halteelement (2) gegenüberliegenden Seite der Adapterplatte (3) Paßeinrichtungen zum Einpassen der Anschlußplatte (5) vorgesehen sind.

2. Adaptervorrichtung nach Anspruch 1, dadurch **gekennzeichnet,** daß die Adapterplatte (3) wenigstens eine durchgehende Bohrung und wenigstens einen Paßstift (8) als Paßeinrichtung für die Anschlußplatte (5) aufweist, wobei in der Bohrung der Adapterplatte (3) ein Stift gehalten ist, der am Halteelement (2) angebracht ist und einen Außendurchmesser hat, der kleiner als der Innendurchmesser der Bohrung der Adapterplatte (3) ist, das Halteelement (2) mit einer Ausnehmung versehen ist, durch die die Anschlüsse der Anschlußleiste in der Adapterplatte (3) zugänglich sind, und der Stift eine Sicherungseinrichtung aufweist, über die das Halteelement (2) und die Adapterplatte (3) relativ zueinander bewegbar miteinander verbunden sind.

3. Adaptervorrichtung nach Anspruch 1, dadurch **gekennzeichnet,** daß das Halteelement (2) eine weitere durchgehende Bohrung aufweist, in der ein Stift gehalten ist, der an der Adapterplatte (3) angebracht ist und einen Außendurchmesser aufweist, der kleiner als der Innendurchmesser der weiteren Bohrung ist,

4. Adaptervorrichtung nach Anspruch 2, dadurch **gekennzeichnet,** daß am Halteelement (2) und an der Adapterplatte (3) jeweils zwei Stifte und zwei durchgehende Bohrungen ausgebildet sind, die bezogen auf den Mittelpunkt dieser Bauelemente (2) und (3) einander diametral gegenüber angeordnet sind.

5. Adaptervorrichtung nach Anspruch 2, dadurch **gekennzeichnet,** daß der wenigstens eine Paßstift an der Adapterplatte (3) an seinem vorderen Ende halbkugelförmig ausgebildet ist.

6. Adaptervorrichtung nach Anspruch 2, dadurch **gekennzeichnet,** daß der am Halteelement (2) vorgesehene wenigstens eine Stift aus einem Bolzen (15) besteht, der auf der Rückseite der Adapterplatte (3) über eine Distanzhülse (16), eine Abdeckscheibe (10) und eine Mutter (17) gesichert ist, wobei die Abdeckscheibe (10) einen Außendurchmesser hat, der größer als der der durchgehenden Bohrung in der Adapterplatte (3) ist, und die Distanzhülse (16) eine Stärke hat, die um einen derartigen Betrag größer als die Stärke der Adapterplatte (3) ist, das bei angezogener Mutter ein kleines Spiel zwischen der Adapterplatte (3) und dem Halteelement (2) bleibt.

Fig. 1

A

1

Fig. 2

8

9

8

1

Fig. 3

Fig. 4

Fig. 5

Fig. 6